Europäisches Patentamt

European Patent Office

Office européen des brevets

(11) Veröffentlichungsnummer: **0 499 998 A2**

# (12) EUROPÄISCHE PATENTANMELDUNG

(21) Anmeldenummer: **92102566.4**

(22) Anmeldetag: **15.02.92**

(51) Int. Cl.⁵: **G03F 1/04**, G03F 9/00

(30) Priorität: **20.02.91 DE 4105284**

(43) Veröffentlichungstag der Anmeldung:
**26.08.92 Patentblatt 92/35**

(84) Benannte Vertragsstaaten:
**DE FR GB IT SE**

(71) Anmelder: **B. BACHER GmbH**
**Eisenbahnstrasse**
**W-7204 Wurmlingen-Tuttlingen(DE)**

(72) Erfinder: **Kensy, Konrad c/o B. Bacher GmbH**
**Eisenbahnstrasse**
**W-7204 Wurmlingen-Tuttlingen(DE)**
Erfinder: **Schweizer, Kurt c/o B. Bacher GmbH**
**Eisenbahnstrasse**
**W-7204 Wurmlingen-Tuttlingen(DE)**

(74) Vertreter: **KOHLER SCHMID + PARTNER**
**Patentanwälte**
**Ruppmannstrasse 27**
**W-7000 Stuttgart 80(DE)**

(54) **Verfahren und Vorrichtung zur videounterstützten Montage.**

(57) Die Erfindung betrifft ein Verfahren und eine Vorrichtung zur videounterstützten Montage von Teilbildern zu einem Montageprodukt. Die Vorrichtung weist einen Montagetisch (10), mindestens eine über dem Montagetisch verfahrbare Videokamera zur Aufnahme eines jeweiligen Teilbildes bzw. eines charakteristischen Merkmals eines Teilbildes und eine Positioniervorrichtung (12; 15-28) auf, mit der die Positionierung jedes Teilbildes mit Hilfe aus dem aufgenommenen Teilbild erzeugter elektronischer Bildpositionssignale erfolgt. Die Montagevorrichtung ist gekennzeichnet durch eine Bildverarbeitungseinrichtung (9), die aus jedem Teilbild (11, 11') automatisch eine charakteristische Kante oder Kontur extrahiert und daraus eine Positionsinformation bezüglich einer für das betreffende Teilbild vorab gespeicherten Bezugsposition ermittelt. Die Positioniervorrichtung ist mit der Bildverarbeitungseinrichtung (9) verbunden und positioniert automatisch jedes Teilbild auf der Grundlage der ermittelten Positionsinformation auf dem Montagetisch, so daß jeweils vorgegebene Positionsbedingungen eingehalten werden.

Fig. 2

EP 0 499 998 A2

Die Erfindung betrifft ein Verfahren und eine Vorrichtung zur videounterstützten Montage von Teilbildern zu einem Montageprodukt, wobei jedes Teilbild auf einem Montagetisch aufgelegt, durch einen Erfassungsschritt jedes Teilbild durch mindestens eine Videokamera erfaßt und durch einen Positionierschritt mit Hilfe aus dem erfaßten Teilbild elektronisch erzeugter Bildsignale so positioniert wird, daß die Position vorgegebene Bedingungen erfüllt.

"Montage" bezeichnet auf dem Gebiet der Drucktechnik einen Herstellungsvorgang bei dem Kopiervorlagen nach einem festgelegten Schema auf einer transparenten Unterlage, der Montagefolie zu einer kopierfähigen Form zusammengefügt werden. Das Montageprodukt ist die kopierfähige Form und stellt eine transparente Montagefolie mit allen aufmontierten Kopiervorlagen und Hilfszeichen dar. Mit "Einpassen" wird das paßgenaue Übereinanderpositionieren aller Farbauszugfilme eines Mehrfarbendrucks bezeichnet.

Unter der Bezeichnung MonTronik (Firma B. Bacher GmbH) ist ein gattungsgemäßes videounterstütztes Montagesystem bekannt. Nach Erstellung eines Grundfilms wird dessen Bild über Videokameras auf zwei Monitore übertragen, und es kann die folgende Farbmontage paßgenau und bildschirmkontrolliert montiert werden. Durch eine wahlweise negative oder positive Bildschirmdarstellung können sowohl Positiv- wie auch Negativfilme einfach und sicher verarbeitet werden. Das Einpassen kann sowohl über Einpaßhilfen, wie Paßkreuze als auch über das Motiv, beispielsweise unter Einbeziehung markanter Konturen erfolgen.

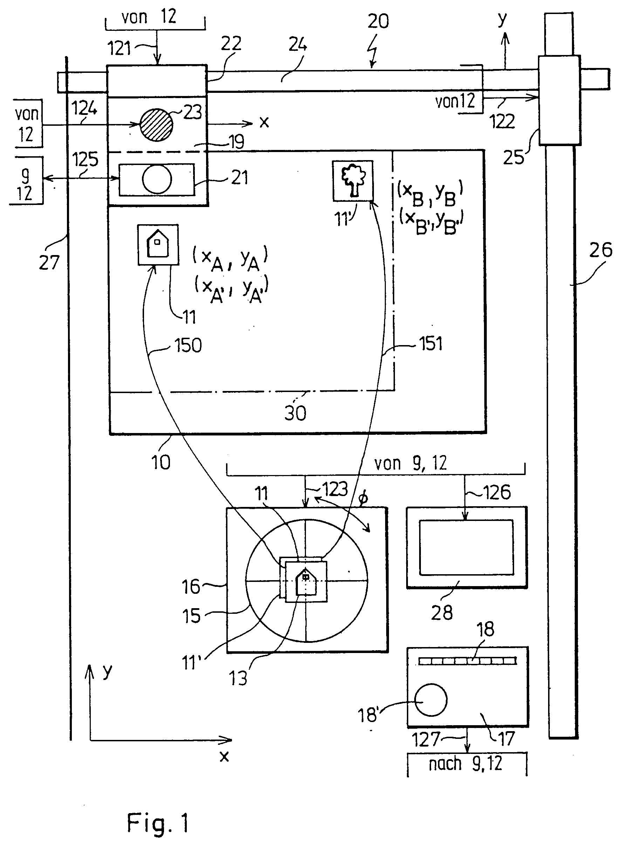

Das bekannte videounterstützte Montagesystem ist schematisch in Figur 1 dargestellt. Ein Montageplatz 1 besteht aus einem Montagetisch 2, der eine lichttransparente, von unten beleuchtbare Platte aufweist, Videokameras 3 und 4, Bildschirmmonitoren 5 und 6 sowie nicht gezeigte Halte- und Bedienelemente. Das bekannte videounterstützte Montagesystem erlaubt folgende manuell ausgeführte Tätigkeiten:
Anlegen der Trägerfolie,
Montieren des ersten Films,
Zentrieren, Ausrichten und Speichern sowie
Versorgen der Montage.

Dann wird über eine Starttaste das Bild der Grundmontage gespeichert und der zweite, dritte und vierte Film bezogen auf die Position des ersten, gespeicherten Films unterstützt durch die an den Videomonitoren 5 und 6 angezeigten Positiv- und/oder Negativdarstellungen der Grundmontage mit Hilfe von durch die Videokameras 3 und 4 aufgenommenen und der Darstellung der Grundmontage überlagerten Bilder manuell positioniert. Dabei ist eine ständige und ermüdende optische Kontrolle der jeweiligen Position durch den Montierer nötig. Unter Bild werden hier und im Folgenden allgemein Darstellungen von Texten, alphanumerische Darstellungen, Tabellen, Bilder usw. verstanden.

Hinzu kommen folgende Erschwernisse:
Die mit den Videokameras 3 und 4 erzeugten Grauwertbilder der Farbauszüge sind gerastert. Mit Rasterung ist gemeint, daß das Bild aus einzelnen Punkten besteht, die gitterförmig angeordnet sind und in der Größe proportional zur korrespondierenden Intensität der Farbe im Originalbild variieren. Von einem Farbauszug zum andern überdecken sich die rechtwinklig angeordneten Punkte nicht, sondern sind gegeneinander verdreht, so daß sie insgesamt ein rosettenförmiges Muster bilden. Dieser Effekt hat keine Bedeutung, solange eine grobe Auflösung vorhanden ist, da sich die Punkte mit den korrespondierenden Punkten der anderen Farbauszüge überlappen. Dieser Effekt wird jedoch besonders störend, sobald eine feinere Auflösung notwendig wird. Bildstrukturen, die sich in 1 : 1 Darstellung ähnlich sind, können sich bei Vergrößerung sehr unterscheiden.

Aus diesem Grunde kann der Montierer, insbesondere weil er auch eine gewisse Drehung einzelner Teilbilder zum Erhalt genau übereinander passender Farbauszüge durchführen muß, besonders bei hochaufgelösten Farbauszügen überfordert sein.

Der Erfindung liegt demnach die Aufgabe zugrunde, ein gattungsgemäßes Verfahren und eine Vorrichtung zur videounterstützten Montage so zu verbessern, daß die Montagearbeit einfacher, sicherer und paßgenauer ausgeführt werden kann.

Der Grundgedanke zur Lösung dieser Aufgabe besteht darin, das paßgenaue Überlagern und Positionieren, d. h. das Montieren mittels digitaler Bildverarbeitung in seiner Genauigkeit zu steigern.

Ein die obige Aufgabe lösendes erfindungsgemäßes Verfahren ist dadurch gekennzeichnet, daß der Erfassungsschritt ein charakteristisches Merkmal eines Teilbildes mittels einer Videokamera erfaßt, einen digitalen Bildverarbeitungsschritt aufweist, welcher automatisch mindestens ein charakteristisches Bildmerkmal extrahiert und eine Positionsinformation des extrahierten Bildmerkmals bezüglich einer vorgegebenen Bezugsposition ermittelt und daß ein Positionierschritt jedes Teilbild mit Hilfe der den extrahierten Bildmerkmalen entsprechenden Positionsinformation automatisch auf dem Montagetisch positioniert.

In einer bevorzugten Ausführungsart stellt das charakteristische Bildmerkmal eine Kante und/oder Kontur des Teilbildes dar und der Erfassungsschritt erfaßt eine solche Kante und/oder Kontur mittels digitaler Kantenfilterung.

Vorteilhafterweise kann diese Kantenfilterung in Echtzeit ausgeführt werden. Damit ist der Vorteil einer beträchtlichen Zeitersparnis verbunden, da die mit Hilfe eines Digitalrechners ausgeführte Kantenfilterung Rechenzeiten von mehreren Minuten haben kann.

Das Verfahren gestattet auch eine automatische Suche nach geeigneten Bildmerkmalen, d.h. Kanten oder Konturen durchzuführen.

Vorzugsweise führt der Positionierschritt eine Positionierung in einer X-Y-Ebene des Montagetisches aus. In einer vorteilhaften Weiterbildung führt der Positionierschritt auch eine Rotation des Teilbildes auf der Basis einer Winkelpositionsinformation der erfaßten Kante und/oder Kontur aus.

Eine die obige Aufgabe lösende Vorrichtung zur videounterstützten Montage ist gekennzeichnet durch eine Bildverarbeitungseinrichtung, die aus jedem Bildausschnitt eines jeweiligen Teilbildes automatisch eine charakteristische Kante und/oder Kontur extrahiert und daraus eine Positionsinformation bezüglich einer für das betreffende Teilbild vorab gespeicherten Bezugsposition ermittelt und durch eine Positioniervorrichtung, die mit der Bildverarbeitungseinrichtung verbunden ist und jedes Teilbild auf der Grundlage der ermittelten Positionsinformation auf dem Montagetisch automatisch so positioniert, daß jeweils vorgegebene Positionsbedingungen erfüllt sind.

Bei einer bevorzugten Ausführungsform weist die Bildverarbeitungseinrichtung ein digitales, in Echtzeit arbeitendes Kantenfilter auf.

Die Positioniervorrichtung weist einen Koordinatenplatz auf, der fest in einer X-Y-Ebene angeordnet ist.

Bei einer bevorzugten Weiterbildung weist die Positioniervorrichtung einen Drehteller auf, der in der X-Y-Ebene fest angeordnet ist und der um eine senkrecht zu dieser Ebene stehende, zentrale Achse drehbar ist.

Die Positioniervorrichtung weist gemäß einer Weiterbildung eine Eingabeeinrichtung auf zur Eingabe von Koordinaten- und Steuerinformationen.

In der bevorzugten Ausführungsform weist die Positioniervorrichtung weiterhin einen Positionierkopf, der die Videokamera und eine Saugvorrichtung enthält und einen den Positionierkopf parallel zur X-Y-Ebene bewegbaren Schlitten mit je einem X- und Y-Linearantrieb auf, dessen Fahrbereich den Koordinatenplatz und den Montagetisch überstreicht.

Ferner weist die Positioniervorrichtung eine mit der Bildverarbeitungseinrichtung verbundene Steuereinrichtung auf, die Steuerinformationen von der Eingabeeinrichtung empfängt und Steuersignale an die Linearantriebe, Drehsteuersignale an einen Drehantrieb des Drehtellers und Saugsteuersignale an die Saugvorrichtung sendet, wobei die Steuereinrichtung auf ein entsprechendes Eingabesignal von der Eingabeeinrichtung die Linearantriebe durch Antriebssteuersignale so steuert, daß der Schlitten den Positionierkopf über dem Drehteller führt, die Saugvorrichtung durch ein Saugsteuersignal so steuert, daß dieser das entsprechende Teilbild mit einem der Drehstellung des Drehtellers entsprechenden Rotationswinkel ansaugt und schließlich die Linearantriebe mit Antriebssignalen auf der Grundlage der ermittelten Positionsinformation so ansteuert, daß diese den Positionierkopf zur gewünschten Position auf dem Montagetisch fahren, wo das Teilbild in der richtigen Position durch Entaktivierung des Saugkopfs abgelegt wird.

Vorzugsweise ist mit der Bildverarbeitungseinrichtung und der Steuereinrichtung eine Anzeigevorrichtung zur Anzeige von Bezugspositionsinformation, extrahierter Positionsinformation und von Bildpixeln des aufgenommenen Teilbildes sowie von Bezugsbildern vorgesehen.

Durch das gekennzeichnete, erfindungsgemäße Verfahren, die erfindungsgemäße Vorrichtung und deren Weiterbildungen sind gegenüber dem Stand der Technik folgende vorteilhafte Funktionen möglich:

1. Die Vorrichtung gestattet bereits die teilautomatische Erstellung der Grundmontage, indem der Montierer auf dem Koordinatenplatz die Bilder der ersten Farbe auflegt, daraufhin mit der Videokamera Bildausschnitte, d. h. geeignete Details eines oder mehrerer Teilbilder aufgenommen und markante Konturen/Kanten aus den Bildausschnitten extrahiert werden. Dann werden die Bilder von dem Koordinatenplatz durch die Saugvorrichtung abgeholt und auf der Grundlage der ermittelten Positionsinformation in Relation zu Vorgaben eines gespeicherten Bogenlayouts in ihrer endgültigen Position auf dem Montagetisch positioniert.

2. Der als Drehteller realisierte Koordinatenplatz ermöglicht es vorteilhafterweise, eine evtl. notwendige Feinkorrektur durch eine Drehung des Bildes durchzuführen.

3. Bei entsprechender Größe des Montagetisches lassen sich die Farbauszüge für mehrere Farben gleichzeitig, d. h. parallel bearbeiten und Montieren.

4. Vorteilhaft läßt sich das erfindungsgemäße Verfahren, bzw. die erfindungsgemäße Vorrichtung zur Erstellung und Montage von Farbauszugbildern zu einem Mehrfarben-Druckmontageprodukt in der Druckvorstufe einsetzen.

Weitere Merkmale der Erfindung werden im folgenden für ein bevorzugtes Ausführungsbeispiel anhand der Zeichnung näher beschrieben. Es zeigen:

Fig. 1 schematisch das bereits beschriebene, gattungsgemäße, videounterstützte Montagesystem;

Fig. 2 schematisch eine bevorzugte Ausführungsart der Erfindung;

Fig. 3 schematisch das Verfahren bei der Montage von mehreren Farbauszügen zu einem Mehrfarb-Montageprodukt; und

Fig. 4 ein vereinfachtes Flußdiagramm der Funktionen der bei der Erfindung verwendeten Bildverarbeitungseinrichtung.

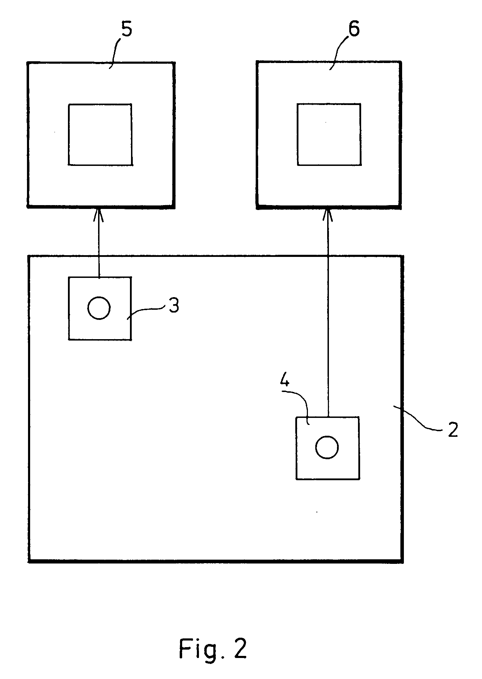

Zunächst wird anhand der Figur 2 eine bevorzugte Ausführungsart des erfindungsgemäßen Verfahrens sowie der erfindungsgemäßen Vorrichtung beschrieben.

Figur 2 zeigt im einzelnen einen Montagetisch 10, einen fest in einem X-Y-Koordinatensystem angeordneten Koordinatenplatz 16 mit einer fadenkreuzartigen Zentralmarkierung die den Koordinatenursprung angibt. Der Koordinatenplatz 16 weist einen um eine Achse, die auf der X-Y-Ebene senkrecht steht, drehbaren Drehteller 15 auf, auf dem Teilbilder 11 und 11' mit Bildausschnitten A und B bzw. A' und B' aufgelegt werden. Durch eine Drehung des Drehtellers 15 läßt sich eine Rotation jedes Teilbildes um einen Winkel φ ausführen. Figur 2 zeigt ferner eine Eingabeeinrichtung 17, die eine Tastatur 18 und eine Rollkugel 18' aufweist. Mit der Tastatur 18 lassen sich Positions- und Steuerinformationen an eine in Figur 2 nur schematisch anhand ihrer Schnittstellen dargestellte Steuereinrichtung eingeben. Eine ähnliche Funktion erfüllt die Rollkugel 18' mit der sich ebenfalls Positionsinformation eingeben und im Echtzeitbetrieb verändern läßt. Eine Anzeigevorrichtung 28 dient zur Anzeige von Positionsinformation und Bildbestandteilen der jeweiligen Teilbilder 11 bzw. 11'. Der Koordinatenplatz 16, insbesondere der Drehteller 15, die Anzeigeeinrichtung 28 und die Eingabeeinrichtung 17 stehen jeweils über Signalleitungen 123, 126 und 127 mit Schnittstellen der Bildverarbeitungseinrichtung 9 sowie der erwähnten Steuereinrichtung 12 in Verbindung. Der Montagetisch 10 und der Drehteller 15 sind von unten beleuchtbar. Alternativ kann der Montagetisch 10 und der Drehteller 15 auch von oben beleuchtet werden, insbesondere wenn keine transparente Trägerfolie benutzt wird, sondern die Teilbilder 11, 11' direkt auf der Druckplatte abgelegt werden.

Ein Positionierkopf 19, der eine Videokamera 21 und eine Vorrichtung 23 enthält, ist durch einen in X- und Y-Richtung verfahrbaren Schlitten 20 über den Montagetisch 10 und den X-Y-Koordinatenplatz hinweg fahrbar. Statt der Saugvorrichtung kann auch jede andere Mitnehmevorrichtung, z. B. eine elektrostatisch aufladbare Hubplatte vorgesehen sein um die Teilbilder 11, 11' vom Koordinatenplatz zum Montagetisch zu bringen. Lineartriebe 22 und 25 dienen jeweils zum Antrieb des Positionierkopfes 19 und des Schlittens 20 in X- und Y-Richtung. Dabei bewegt sich der Positionierkopf 19 längs einer X-Schiene 24, während sich der Schlitten 20 längs einer ersten Y-Schiene 26 und einer parallel dazu geführten zweiten Y-Schiene 27 bewegen kann.

Der X-Linearantrieb 22 wird durch eine Ansteuerleitung 121 von der Steuereinrichtung 12 angesteuert. Der Y-Linearantrieb 25 wird durch eine Ansteuerleitung 122 von der Steuereinrichtung 12 angesteuert. Die Saugvorrichtung 23 erhält von der Steuereinrichtung 12 Steuersignale über eine Leitung 124. Die Videokamera 21 steht mit der Steuereinrichtung 12 und der Bildverarbeitungseinrichtung 9 über Signalleitungen 125 in Verbindung. Die Bildverarbeitungseinrichtung 9 und die Steuereinrichtung 12 sind vorteilhafterweise gemeinsam als Funktionsteile eines in Fig. 2 nicht gezeigten Digitalrechners mit entsprechenden in Fig. 2 nur schematisch angegebenen Ein-/Ausgabeschnittstellen ausgeführt. Dieser Digitalrechner weist auch einen Bildspeicher auf zum Speichern von Bezugsbildinformationen, insbesondere Bogenlayout-Bildinformation und von Bildinformation, die durch die Videokamera 21 von den Teilbildern 11 und 11' aufgenommen wurde.

Anhand der in Figur 2 gezeigten bevorzugten Ausführungsform der erfindungsgemäßen Montagevorrichtung erfolgt nun die Beschreibung einer bevorzugten Ausführungsart eines erfindungsgemäßen Verfahrens und damit die Funktionsbeschreibung der Montagevorrichtung. Dabei geht es zunächst um die Grundmontage, d. h. die Erstellung einer ersten Farb- Teilmontage, beispielsweise einer Folie für einen Cyan-Farbauszug. Zunächst wird auf dem Montagetisch 10 eine Montagegrundfolie 30 in einer gewünschten Position aufgelegt, mit Hilfe einer Koordinatenschiene oder auf dem Montagetisch 10 aufgebrachten Hilfsmarken im X-Y-Koordinatensystem ausgerichtet und fixiert. Auf dem Drehteller 15 des Koordinatenplatzes 16 werden nacheinander Teilbilder 11 und 11' in zentraler Position aufgelegt. Dann wird der Positionierkopf 19 mit Hilfe an der Eingabeeinrichtung 17 über die Tastatur 18 eingegebener Steuersignale mittels des Schlittens 20 über einen Bildausschnitt A des ersten Teilbildes 11 gefahren. Feinkorrekturen zur genauen Festlegung der Lage der Videokamera 21 über dem ersten Bildausschnitt A lassen sich mittels der Rollkugel 18' an der Eingabeeinrichtung 17 durchführen. Die Videokamera 21 befindet sich dann genau über dem ersten Bildausschnitt A und nimmt auf ein weiteres Steuersignal ein Bild davon auf. Auf der Basis dieses aufgenommenen Videobildes wird nun mittels eines in der Bildverarbeitungseinrichtung 9 enthaltenen digitalen Kantenfilters eine markante Kontur 13 des Bildausschnitts A extrahiert und deren Positionskoordinaten bezogen auf einen virtuellen Koordinaten Ursprung gespeichert.

Schritthaltend damit werden an der Anzeigeeinrichtung 28 Bilddarstellungen des jeweils aufgenommenen Teilbildes bzw. des Bildausschnitts davon und Bezugspositionsinformation nach Maßgabe des im Rechnerspeicher gespeicherten Bogenlayouts alphanumerisch und/oder graphisch angezeigt. Mit Hilfe üblicher Graphik-Dialogprogramme wird der Montierer zur Eingabe von Positionsinformation $X_A$ und $Y_A$, die sich auf vom gespeicherten Bogenlayout abgeleitete Bezugspositionsinformationen bezieht, angeleitet. Auf ein weiteres an der Eingabeeinrichtung 17 mittels der Tastatur 18 eingegebenes Steuersignal saugt die Saugvorrichtung 23 das Teilbild 11 an und der Positionierkopf 19 fährt zur festgelegten Position über den Montagetisch 10, bzw. die Montagefolie 30 (Weg 150) und legt das Teilbild 11 am angegebenen Ort mit den Koordinaten $x_A$ und $y_A$ ab. Die jeweiligen Teilbilder haften auf der Oberfläche der Montagefolie 30, z. B. durch Adhäsion oder elektrostatische Kräfte; sie können auch aufgeklebt werden.

In der gleichen Weise wird nun die Positionierung eines weiteren Teilbildes, das in Figur 2 mit 11' bezeichnet ist und dessen Bildausschnitt B eine markante Kontur 14 aufweist, die durch die Bildverarbeitungseinrichtung 9 extrahiert werden kann, über einen Weg 151 auf der Montagefolie 30 an einer Position $x_B$ und $y_B$ auf dem Montagetisch 10 positioniert. Die Wege 150 und 151 sind selbstverständlich nur beispielhaft angegeben.

Die oben beschriebenen Verfahrensschritte werden nun solange ausgeführt, bis alle gewünschten Teilbilder auf dem Montagetisch 10 bzw. der Montagegrundfolie 30 positioniert sind, wodurch das Positionierverfahren für die Grundmontage, beispielsweise für einen Cyan-Auszug beendet ist.

Die Positioniervorrichtung speichert dann sämtliche Koordinaten der Positionen jedes auf der Montagegrundfolie 30 auf dem Montagetisch 10 aufgebrachten Teilbilds bzw. die Koordinaten der Positionen der erfaßten Kanten jedes Bildausschnitts.

Diese gespeicherten Positionskoordinaten dienen dann als Grundlage für die Montage weiterer Farbauszüge, wie weiter unten beschrieben wird.

Zuvor soll noch eine vorteilhafte Weiterbildung der bei der Erfindung verwendeten Konturerfassung jedes Teilbildes beschrieben werden.

Die Positioniergenauigkeit läßt sich noch steigern, wenn statt nur einer markanten Kontur eines Teilbildes noch eine oder mehrere weitere Konturen zur Positionserfassung und Speicherung erfaßt werden können. Wenn beispielsweise das Teilbild 11 außer dem Bildausschnitt A einen Bildausschnitt A' mit einer weiteren zur Erfassung geeigneten Kante aufweist, so wird bei der Erfassung des Teilbildes mittels der Videokamera 21 entweder automatisch oder durch einen entsprechenden an der Eingabeeinrichtung 17 eingegebenen Befehl bewirkt, daß die Positionsinformationen über die Koordinaten der zweiten Kante oder Kontur des weiteren Bildausschnitts bezüglich der Grundposition des Bogenlayouts oder Einteilungsbogens erfaßt und abgespeichert werden. Diese Koordinateninformation besteht dann beispielsweise aus dem Koordinatensatz $(x_{A'}, y_{A'})$. Genauso kann für das zweite Teilbild 11' ein weiterer Koordinatensatz $(X_{B'}, Y_{B'})$ aus einem weiteren Bildausschnitt B' ermittelt und abgespeichert werden. Alternativ kann die Positionierung der Teilbilder der Grundmontage direkt auf der Montagegrundfolie von Hand ausgeführt werden und ausgehend von dieser Grundmontage mit Hilfe der Videokamera eine oder mehrere markante Konturen pro Teilbild erfaßt und extrahiert und deren Positionsinformation im Rechnerspeicher abgespeichert werden.

Diese Grundpositionskoordinaten dienen dann als Grundlage für die Montage weiterer Farbauszüge.

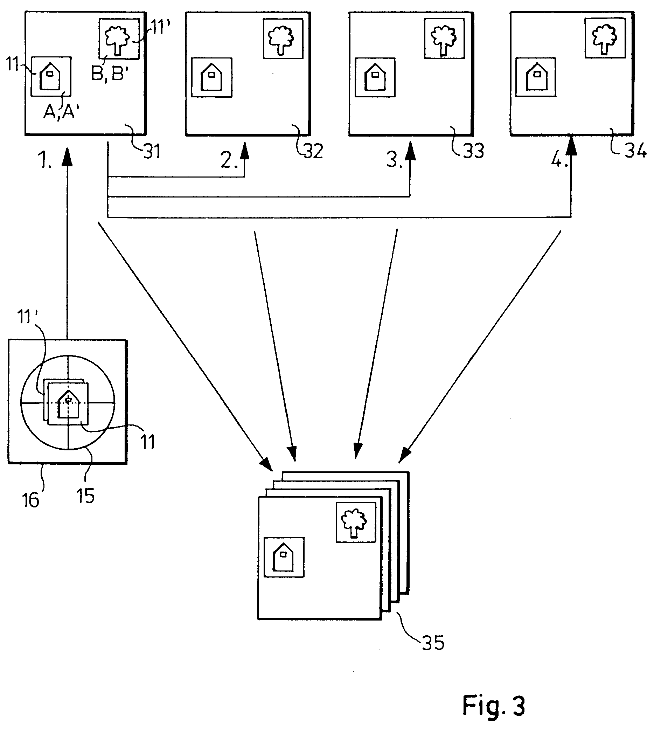

Anhand der Figur 3 wird nachstehend ein Verfahren erläutert, welches ausgehend von einem nach den obigen Verfahren montierten Cyan-Farbauszug 31 weitere Farbauszüge 32, 33 und 34 erstellt und schließlich zu einem Mehrfarb-Montageprodukt 35 kombiniert. Dabei dienen die Koordinaten der bei der Grundmontage des Cyan-Farbauszugs 31 extrahierten Kanten oder Konturen der Bildausschnitte A, A' und B, B' der Teilbilder 11 und 11' als Basis für die mittels Bildkorrelation durchgeführte Montage der weiteren Farbauszüge 32 bis 34.

Beim Betrachten von Farbauszügen ergibt sich, daß der Inhalt dieser Bilder meist sehr unterschiedlich ist. Jedoch sind allen Bildern bestimmte markante Stellen, Konturen oder Kanten gemeinsam, die sich als Grundlage für eine paßgenaue Montage der Grundmontage dem Cyan-Farbauszug folgenden Farbmontagen die Gelb-, Magenta- und Schwarzfarbauszüge 32, 33 34 anbieten.

Wenn das Format der Montagefolie 30 so ist, daß auf dem Montagetisch 10 die Montagefolien für mehrere Farbauszüge Platz finden, kann die Montage der weiteren Farbauszüge "gelb", "magenta", "schwarz" ausgehend von der Grundmontage, dem Cyan-Farbauszug 31 im wesentlichen parallel erfolgen. Der Übergang von einer Montage zur nächsten wird dabei durch entsprechende Steuerbefehle von der Eingabeeinrichtung 17 initiiert.

Die für jede einzelne Montage ablaufenden Verfahrensschritte bestehen jeweils aus:

- Auflegen des Einzelfilms bzw. Teilbilds auf den Drehteller 15;
- Positionieren des Positionierkopfes 19 über den einzelnen Bildausschnitten des Einzelfilms;

- Videoaufnahme von Bildausschnitten des Einzelfilms bzw. Teilbilds;
- Extraktion markanter Kanten oder Konturen davon;
- Korrellation von Positionsinformation der extrahierten Kanten oder Konturen mit zuvor gespeicherter Koordinateninformation entsprechender Kanten aus der Grundmontage;
- Berechnen von Positionsabweichungen in Translation und Rotation;
- Kompensation der Rotationsabweichung durch Drehung des Einzelfilmes auf dem Drehteller 15; und
- automatisches Ablegen der jeweiligen Einzelfilme in der korrekten Position unter Berücksichtigung der berechneten Abweichungen auf der Montagefolie 30 bzw. 31 bis 34 auf dem Montagetisch 10.

Selbstverständlich muß zuvor die absolute Position der jeweiligen parallel auf dem Montagetisch 10 liegenden Montagefolien der Bildverarbeitungseinrichtung 9 und der Steuereinrichtung 12 der Positioniervorrichtung über die Eingabeeinrichtung 17 eingegeben werden.

Die Farbauszüge 31 bis 34 bilden schließlich einen Mehrfarbmontagesatz 35.

Die Anforderungen an ein automatisch arbeitendes Einpaßsystem sind:

1. Es sollen Strukturen und Konturen, die explizit in allen vier Farbauszügen vorhanden sind, überlagert werden;

2. Die Zeit für die Berechnung der Überlagerung aller vier Farbauszüge soll weniger als 60 Sekunden betragen;

3. Der Einpaßtisch soll in einem X-Y-Koordinatensystem sowie um eine Drehachse $\phi$ so gesteuert werden, daß die Überlagerung eine Genauigkeit von 10 bis 50 $\mu$m hat.

Farbauszüge, die durch digitale Bildverarbeitung zur Überlagerung gebracht werden sollen, haben häufig ein beträchtlich großes Format. Beispielsweise 42 x 30 cm.

Trotzdem läßt sich die geforderte Genauigkeit durch Anwendung der oben bereits beschriebenen Bildextraktionsalgorithmen erzielen.

Markante Konturen in den Bildausschnitten werden mit Hilfe des oben beschriebenen Kantenerfassungsalgorithmus erfaßt.

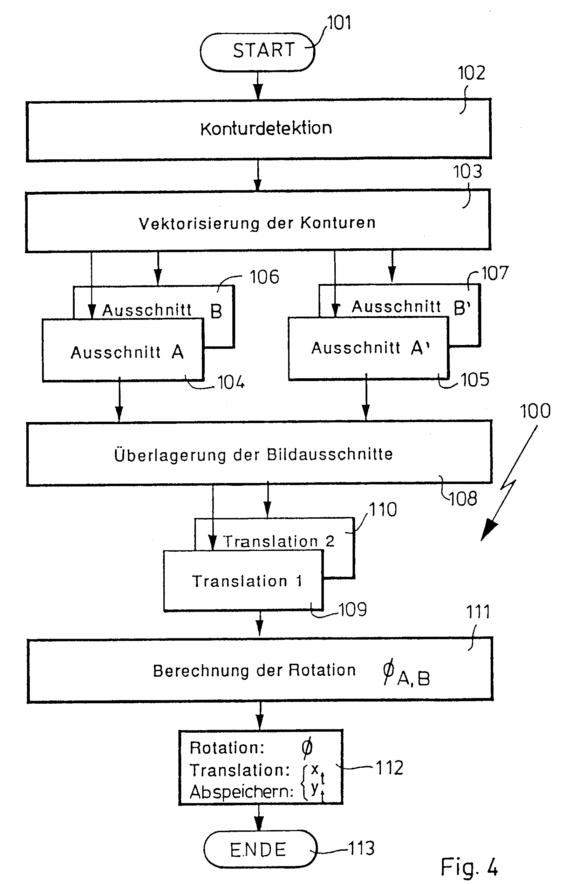

Anhand der Figur 4 wird nun ein Einpaßprozeß 100 mittels eines Flußdiagramms beschrieben.

Nach einem Startschritt 101 wird in einem Schritt 102 die bereits erwähnte Konturerfassung ausgeführt. Dies geschieht vorzugsweise in zwei möglichst weit auseinanderliegenden Bildausschnitten A und A' bzw. B, B' eines Farbauszugs. Diese Ausschnitte sollten besonders deutliche Konturen und/oder Kanten beinhalten, damit nachfolgende Überlagerung der Bildausschnitte zu stabilen und genauen Resultaten führen. In einem Schritt 103 werden die im vorangehenden Schritt 102 erfaßten Konturen vektorisiert. In einem Schritt 108 werden die in Schritten 104 bis 107 ausgewählten Bildausschnitte A, A' und B, B' eines ersten und zweiten Farbauszugs zur Überlagerung gebracht.

Anschließend werden in Schritten 109 und 110 eine erste und zweite Translation bei der Überlagerung der korrespondierenden Bildausschnitte berechnet.

Das dazu verwendete Korrelationsverfahren beruht, wie schon erwähnt, auf der Grundlage der erfaßten und in Vektoren umgesetzten Konturen und nicht auf Pixelbasis.

Anschließend wird in einem Schritt 111 die Rotation $\phi$ aufgrund der unterschiedlichen Translation der beiden zur Deckung gebrachten Bildausschnitte gerechnet. Aus diesem Grund ist es notwendig, daß die beiden Bildausschnitte A, A' bzw. B, B' möglichst weit voneinander entfernt liegen, damit der Fehler des Drehwinkels möglichst gering ist.

Die sich ergebenden Koordinatenwerte x und y der Translation und der Wert der Rotation $\phi$ werden in einem Schritt 112 abgespeichert und schließlich der Einpaßprozeß 100 beendet (Schritt 113).

Der Einpaßprozeß 100 wird sequentiell für jeden einzelnen Farbauszug auf der Grundlage eines ersten geeigneten Farbauszugs, beispielsweise des Cyan-Farbauszugs 31 durchgeführt, bis schließlich der Mehrfarben-Montagesatz 35 mit sämtlichen eingepaßten Farbauszugsfilmen 31 bis 34 fertiggestellt ist.

Obwohl das erfindungsgemäße Verfahren und die erfindungsgemäße Vorrichtung besonders in ihrer Verwendung bei der Montage von Teilbildern zu einem Montageprodukt sowie zum Einpassen in der Druckvorbereitungsstufe zur Herstellung eines Mehrfarben-Montageprodukts beschrieben wurden, lassen sich weitere Verwendungszwecke angeben. Darüberhinaus ist die Erfindung auch auf dem Gebiet der Kartographie und Geographie sowie bei der Layout-Erstellung für integrierte Halbleiterschaltungen, also überall dort anwendbar, wo paßgenau Einzelbilder ohne Paßmarken unter Bezug auf die Bildinhalte zu einem Gesamtbild zusammengesetzt werden.

**Patentansprüche**

1. Verfahren zur videounterstützten Montage von einzelnen Teilbildern zu einem Montageprodukt, wobei jedes der Teilbilder auf einem Montagetisch aufgelegt, durch einen Erfassungsschritt jedes Teilbild durch mindestens eine Videokamera erfaßt und durch einen Positionierschritt mit Hilfe aus dem erfaßten Teilbild elektronisch erzeugter Bildsignale so positioniert wird, daß die Position vorgegebene Bedingungen erfüllt,

dadurch gekennzeichnet, daß

der Erfassungsschritt durch eine digitale Bildverarbeitung automatisch mindestens eine im Teilbild enthaltene charakteristische Kante und/oder Kontur extrahiert und eine Positionsinformation des extrahierten Bildmerkmals bezüglich einer vorgegebenen Bezugsposition ermittelt, und der Positionierschritt jedes Teilbild automatisch in einer X-Y-Ebene auf dem Montagetisch auf der Basis der Positionsinformation positioniert.

2. Verfahren nach Anspruch 1,

dadurch gekennzeichnet, daß

der Erfassungsschritt die Kantenerfassung mittels einer digitalen Kantenfilterung on-line ausführt.

3. Verfahren nach Anspruch 1 oder 2,

dadurch gekennzeichnet, daß

der Positionierschritt zusätzlich eine Rotation des Teilbildes auf der Basis einer Winkelpositionsinformation ausführt.

4. Verfahren nach einem der vorangehenden Ansprüche,

dadurch gekennzeichnet, daß

eine automatische Suche nach geeigneten Bildmerkmalen durchgeführt wird.

5. Vorrichtung zur videounterstützten Montage von Teilbildern zu einem Montageprodukt mit
   - einem Montagetisch (10),
   - mindestens einer Videokamera (21) zur Aufnahme mindestens eines Bildausschnittes eines jeweiligen Teilbildes (11, 11'), wobei die Positionierung jedes Teilbildes mit Hilfe aus dem aufgenommenen Bildausschnitt erzeugter elektronischer Bildsignale erfolgt,
   gekennzeichnet durch
   - eine Bildverarbeitungseinrichtung (9), die aus jedem Bildausschnitt automatisch eine charakteristische Kante oder Kontur extrahiert und daraus eine Positionsinformation bezüglich einer für das betreffende Teilbild (11, 11') vorab gespeicherten Bezugsposition ermittelt, und
   - eine Positioniervorrichtung (12; 15 - 28), die mit der Bildverarbeitungseinrichtung (9) verbunden ist und jedes Teilbild auf der Grundlage der ermittelten Positionsinformation auf dem Montagetisch (10) automatisch so positioniert, daß jeweils vorgegebene Positionsbedingungen erfüllt sind.

6. Vorrichtung nach Anspruch 5,

dadurch gekennzeichnet, daß

die Bildverarbeitungseinrichtung (9) ein digitales on-line Kantenfilter aufweist.

7. Vorrichtung nach Anspruch 5 oder 6,

dadurch gekennzeichnet, daß

die Positioniervorrichtung einen Drehteller (15) aufweist, der in der X-Y-Ebene festliegt und um eine senkrecht zu dieser Ebene stehende, zentrale Achse drehbar ist.

8. Vorrichtung nach einem der Ansprüche 5 bis 7,

dadurch gekennzeichnet, daß

die Positioniervorrichtung eine Eingabeeinrichtung (17) zur Eingabe von Koordinaten- und Steuerinformationen, einen Positionierkopf (19), der die Videokamera (21) und eine Saugvorrichtung (23) zum Ansaugen eines auf dem Drehteller aufgelegten Teilbildes enthält, und

einen den Positionierkopf (19) parallel zur X-Y-Ebene bewegbaren Schlitten (20) mit je einem X- und Y-Linearantrieb (22, 25) aufweist, dessen Fahrbereich den Koordinatenplatz (16) und den Montagetisch (10) überstreicht.

9. Vorrichtung nach einem der Ansprüche 5 bis 8,

dadurch gekennzeichnet, daß

die Positioniervorrichtung eine mit der Bildverarbeitungseinrichtung (9) verbundene Steuereinrichtung (12) aufweist, die Steuerinformation von der Eingabeeinrichtung (17) empfängt und Steuersignale (121, 122) jeweils an den X- und Y-Linearantrieb (22, 25), Drehsteuersignale (123) an einen den Drehteller antreibenden Drehantrieb und Saugsteuersignale (124) an die Saugvorrichtung (23) sendet, wobei

die Steuereinrichtung (12) auf ein entsprechendes Eingabesteuersignal von der Eingabeeinrichtung (17) den X-Linearantrieb (22) und/oder den Y-Linearantrieb (25) jeweils durch die Steuersignale (121, 122) so ansteuert, daß der Schlitten (20) den Positionierkopf (19) über den Drehteller fährt,

daraufhin die Saugvorrichtung (23) durch ein entsprechendes Saugsteuersignal (124) so ansteuert, daß die Saugvorrichtung das entsprechende Teilbild mit einem der Drehstellung des Drehtellers (15) entsprechenden Rotationswinkel ($\phi$) ansaugt, und

schließlich den X-Linearantrieb (22) und/oder den Y-Linearantrieb (25) mit der ermittelten Positionsinformation so ansteuert, daß diese den Positionierkopf zur gewünschten Position auf dem Montagetisch fahren, wobei das angesaugte Teilbild abgelegt wird.

10. Vorrichtung nach einem der Ansprüche 5 bis 9,

dadurch gekennzeichnet, daß mit der Bildverarbeitungseinrichtung eine Anzeigevorrichtung (28) mindestens zur Anzeige von Bezugspositionsinformation, extrahierter Positionsinformation, von Bildausschnitten des aufgenommenen Teilbildes sowie Bildausschnitten eines Bezugsbildes vorgesehen ist.

Fig. 1

Fig. 2

Fig. 3

Fig. 4